# EUROPEAN PATENT APPLICATION

(11) **EP 4 742 845 A1**
(43) Date of publication of application: **13.05.2026**
(21) Application number: 24848142.6
(22) Date of filing: 25.07.2024
(51) Int. Cl.: H05K 7/20

(54) **COMMUNICATION DEVICE**

(30) Priority: 28.07.2023 CN 202310952110
(71) Applicant: Huawei Technologies Co., Ltd., Shenzhen, Guangdong 518129 (CN)
(72) Inventor: ZHANG, Yuandong, Shenzhen, Guangdong 518129 (CN); HUANG, Fei, Shenzhen, Guangdong 518129 (CN); HU, Weifeng, Shenzhen, Guangdong 518129 (CN); ZHANG, Shufeng, Shenzhen, Guangdong 518129 (CN)
(74) Representative: Maiwald GmbH
(86) International application number: PCT/CN2024/107617
(87) International publication number: WO 2025/026185

(57) **Abstract**

This application provides a communication device, and relates to the field of communication technologies, to resolve a technical problem about a poor effect of heat dissipation for communication devices. The communication device provided in this application may include a housing, a first heat emitting component, a second heat emitting component, and an air guide pipe. The housing has a heat dissipation air duct and an air inlet and an air outlet that are in communication with the heat dissipation air duct. The first heat emitting component and the second heat emitting component are both located in the heat dissipation air duct. The air guide pipe is located in the heat dissipation air duct, the air guide pipe has an air inlet end and an air outlet end, and the air inlet end is in communication with the air inlet end. The first heat emitting component is located at the air outlet end of the air guide pipe. One part of air entering from the air inlet may dissipate heat for the second heat emitting component, and the other part of the air may cool the first heat emitting component through the air guide pipe, thereby ensuring efficiency of heat dissipation for the first heat emitting component.

## Description

### CROSS-REFERENCE TO RELATED APPLICATIONS

This application claims priority to Chinese Patent Application No. 202310952110.7, filed with the China National Intellectual Property Administration on July 28, 2023 and entitled "COMMUNICATION DEVICE", which is incorporated herein by reference in its entirety.

### TECHNICAL FIELD

This application relates to the field of communication technologies, and in particular, to a communication device.

### BACKGROUND

With rapid development of electronic technologies, electronic devices are highly integrated than ever and their thermal densities are increasingly high. Usually heat dissipation is required for electronic components to ensure good performance and reliability of the electronic components. In a current electronic device, heat dissipation is usually performed on an electronic component in an air cooling manner, and heat of the electronic component is reduced by air that flows through a surface of the electronic component, to control the electronic component to operate in a proper temperature range. Existing communication devices such as a building baseband unit (building baseband unit, BBU) and a radio HUB (radio HUB, RHUB) unit are mainly applied to scenarios such as office buildings, shopping malls, and subways, to implement functions such as signal encryption and coverage hole filling. Such communication devices have high requirements on heat dissipation and noise, and different electronic components in the communication devices have different requirements on heat dissipation. However, to satisfy a high requirement of an electronic component on heat dissipation in conventional technologies, usually a heat dissipation capability of the entire communication device is enhanced, for example, usually by directly increasing an air volume of a fan and a quantity of in-use fans. Such a solution lacks research and optimization for the device in practical application. Increasing the quantity of fans brings about an increase in a size and a weight of the communication device, and increasing the air volume of the fan causes loud noise. Therefore, how to improve heat dissipation performance of some electronic components in a communication device is an urgent technical problem to be resolved.

### SUMMARY

This application provides a communication device with good heat dissipation performance.

The communication device may include a housing, a first heat emitting component, a second heat emitting component, and an air guide pipe. The housing has a heat dissipation air duct and an air inlet and an air outlet that are in communication with the heat dissipation air duct. The first heat emitting component and the second heat emitting component are both located in the heat dissipation air duct. The air guide pipe is located in the heat dissipation air duct, the air guide pipe has an air inlet end and an air outlet end, and the air inlet end is in communication with the air inlet. The first heat emitting component is located at the air outlet end of the air guide pipe. During practical application, external air may enter the heat dissipation air duct from the air inlet, and is discharged from the air outlet. One part of air entering from the air inlet flows through the second heat emitting component, to dissipate heat for the second heat emitting component, and is ultimately discharged from the air outlet. In addition, the air inlet end of the air guide pipe is in communication with the air inlet. Therefore, the other part of the air entering from the air inlet enters the air guide pipe from the air inlet end and then is discharged from the air outlet end. The first heat emitting component is located at the air outlet end of the air guide pipe. Therefore, when the air discharged from the air outlet end flows through the first heat emitting component, the first heat emitting component can be cooled, thereby ensuring efficiency of heat dissipation for the first heat emitting component.

During specific arrangement, the air guide pipe may have a thermal insulation side wall, and the thermal insulation side wall is disposed facing the second heat emitting component. Heat generated by the second heat emitting component can be effectively blocked through the thermal insulation side wall, to prevent the heat generated by the second heat emitting component from being transferred to the air guide pipe and causing a temperature rise of air in the air guide pipe, thereby effectively ensuring efficiency of heat dissipation for the first heat emitting component.

Alternatively, during specific arrangement, the entire air guide pipe may be made of a thermal insulation material, thereby improving convenience of manufacturing and helping reduce a size of a heat conduction pipe.

In an example, the air guide pipe may have one air inlet end and a plurality of air outlet ends. An air deflector is further disposed in the air guide pipe, and the air deflector is configured to guide a volume of flow in the air guide pipe to each air outlet end. The air deflector can effectively distribute and guide the volume of flow in the air guide pipe, so that there is a sufficient volume of flow at each air outlet end, thereby ensuring efficiency of heat dissipation for the communication device.

During specific arrangement, the air guide pipe may be in a long strip shape, and the plurality of air outlet ends are sequentially disposed in a length direction of the air guide pipe, so that a length of the air guide pipe can be efficiently utilized for the air guide pipe to have more air outlet ends. During specific arrangement of the air deflector, a plurality of air deflectors may be sequentially disposed in the length direction of the air guide pipe, so that airflow in the air guide pipe can be effectively distributed and guided.

During specific arrangement, in a connection path between the air inlet end and the air outlet end of the air guide pipe, the air guide pipe is in a straight line shape or a curve shape.

In an example, a diameter of the air inlet is greater than a diameter of the air inlet end, so that one part of the air entering from the air inlet can dissipate heat for the second heat emitting component, and the other part of the air can dissipate heat for the first heat emitting component through the air guide pipe, thereby effectively taking into account both efficiency of heat dissipation for the first heat emitting component and efficiency of heat dissipation for the second heat emitting component.

During specific arrangement, the communication device may further include a first fan. The first fan is located at the air inlet or the air outlet of the housing, or the first fan may be arranged at both the air inlet and the air outlet. The first fan is configured to inhale external air into the air inlet, to effectively dissipate heat for the first heat emitting component and the second heat emitting component.

In an example, the communication device further includes a second fan. The second fan is located at the air inlet end or the air outlet end, or the second fan is located in the air guide pipe. The second fan can accelerate circulation of air in the air guide pipe, thereby improving efficiency of heat dissipation for the first heat emitting component.

In an example, an outer surface of the air guide pipe may be provided with an avoidance slot, and at least a part of the second heat emitting component is located in the avoidance slot, to prevent position interference between the second heat emitting component and the air guide pipe.

In an example, the communication device may further include a heat sink, and the heat sink is located in the heat dissipation air duct and is in thermal conduction contact with the second heat emitting component. A heat dissipation area of the second heat emitting component may be effectively increased through the heat sink, thereby improving efficiency of heat dissipation for the second heat emitting component.

During specific arrangement, the heat sink may have heat sink fins, and an air duct for air circulation may be formed between two neighboring heat sink fins. In addition, the air guide pipe may be located on the top of the heat sink fin, so that the air guide pipe and the heat sink fin can jointly form an enclosed air duct to improve air circulation efficiency, thereby improving efficiency of heat dissipation for the second heat emitting component.

In an example, the air guide pipe may have a pipe body and a heat dissipation portion that is disposed on an outer side of the pipe body, and the heat dissipation portion is in thermal conduction contact with the second heat emitting component. Heat generated by the second heat emitting component can be transferred to the heat dissipation portion, and the heat is effectively dissipated through the heat dissipation portion, thereby effectively improving efficiency of heat dissipation for the second heat emitting component.

In an example, the air guide pipe may have a thermal insulation portion, and the thermal insulation portion is located between the pipe body and the heat dissipation portion. The thermal insulation portion can effectively perform isolation with regard to heat transfer between the pipe body and the heat dissipation portion, to prevent heat transfer from the heat dissipation portion to the pipe body, thereby ensuring efficiency of heat dissipation for the first heat emitting component.

During specific arrangement, the first heat emitting component may include a plurality of optical modules, and the plurality of optical modules may be sequentially disposed in the length direction of the air guide pipe, to effectively utilize space. In addition, more air outlet ends may be disposed in the length direction of the air guide pipe, thereby effectively dissipating heat for the plurality of optical modules.

In an example, the second heat emitting component includes a circuit board and a plurality of electronic components located on the circuit board. The electronic component may be specifically a chip, a power conversion device, or the like. During specific application, a quantity of the electronic components and types of the electronic components may be properly arranged according to an actual requirement.

During specific application, the communication device may be specifically a building baseband unit or a radio HUB unit. Targeted heat dissipation for different electronic components in the communication device can be performed through the air guide pipe, thereby improving overall heat dissipation performance of the communication device.

### BRIEF DESCRIPTION OF DRAWINGS

FIG. 1 is a diagram of an application architecture of a communication device according to an embodiment of this application;
FIG. 2 is a plan view of a structure of a conventional communication device according to an embodiment of this application;
FIG. 3 is a simplified plan view of a structure of a communication device according to an embodiment of this application;
FIG. 4 is a plan view of a structure of a communication device according to an embodiment of this application;
FIG. 5 is a perspective view of a structure of an air guide pipe according to an embodiment of this application;
FIG. 6 is a sectional view of a structure of an air guide pipe according to an embodiment of this application;
FIG. 7 is a plan view of a structure of another communication device according to an embodiment of this application;
FIG. 8 is a partial sectional view of a structure of another communication device according to an embodiment of this application; and
FIG. 9 is a perspective view of a structure of another air guide pipe according to an embodiment of this application.

### Reference numerals:

01: radio HUB unit; 10: communication device; 11: housing; 12: first heat emitting component; 13: second heat emitting component; 14: air guide pipe; 15: power supply unit; 16: fan; 17: heat sink;
011: housing; 012: fan; 013: circuit board assembly; 014: optical module; 015: power supply unit; 111: heat dissipation air duct; 112: air inlet; 113: air outlet; 120: optical module; 131: circuit board; 132: electronic component; 13a: second heat emitting component; 13b: second heat emitting component; 140: pipe body; 141: air inlet end; 142: air outlet end; 144: avoidance slot; 145: heat dissipation portion; 146: thermal insulation portion; 171: heat sink fin; 172: air duct; 17a: heat sink; 17b: heat sink;
131a: circuit board; 131b: circuit board; 132a: electronic component; 132b: electronic component; 142a: air outlet end; 142b: air outlet end; 142c: air outlet end; 143a: air deflector; 143b: air deflector; 171a: fin; 171b: fin; 172a: air duct; 172b: air duct.

### DESCRIPTION OF EMBODIMENTS

To make the objectives, technical solutions, and advantages of this application clearer, the following further describes this application in detail with reference to the accompanying drawings.

For ease of understanding a communication device provided in embodiments of this application, the following first describes an application scenario of the communication device.

The communication device provided in embodiments of this application may be applied to a digital indoor system (digital indoor system, DIS) to implement effective coverage with indoor communication signals.

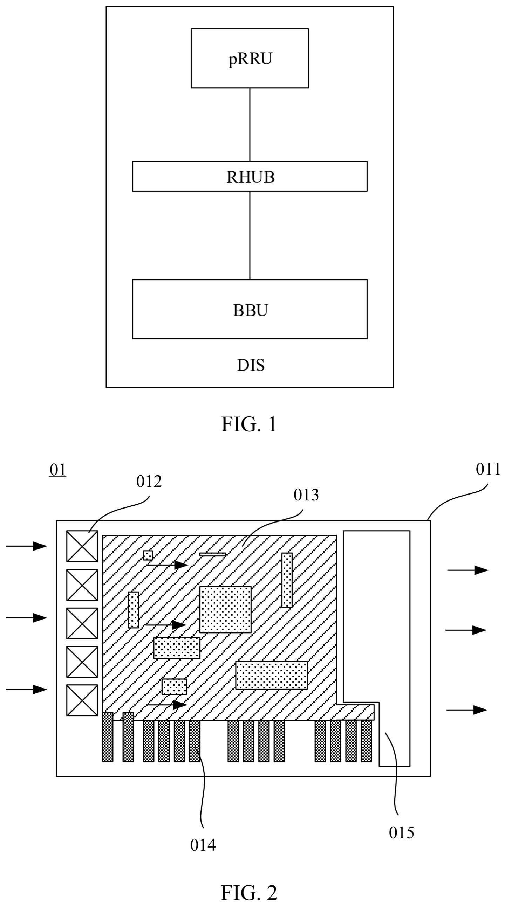

For example, as shown in FIG. 1, a digital indoor system (digital indoor system, DIS) may include a pico remote radio unit (pico remote radio unit, pRRU), a radio HUB (radio HUB, RHUB) unit, and a building baseband unit (building baseband unit, BBU). The radio HUB unit may be connected to the pico remote radio unit and the building baseband unit through an optical/electrical hybrid cable or a network cable. The pico remote radio unit, also known as a pico base station, is a pico cellular base station with a small size, low power, and low power consumption, mainly aiming to address an issue of indoor radio signal coverage in a specific area. As a network element in an indoor coverage solution, the radio HUB unit needs to cooperate with the pico remote radio unit and the building baseband unit. The radio HUB unit is configured to receive downlink baseband data sent by the building baseband unit, transmit the downlink baseband data to the pico remote radio unit after branching processing, and combine uplink baseband data from the pico remote radio unit before sending the uplink baseband data to the building baseband unit.

During practical application, the communication device provided in this application may be specifically a box-shaped communication device, such as the building baseband unit (building baseband unit, BBU) or the radio HUB (radio HUB, RHUB) unit. The communication device may be applied to a scenario such as an office building, a shopping mall, or a subway, and is configured to implement communication signal encryption, coverage hole filling, and the like. During practical application, the communication device may be installed in an enclosed environment such as an indoor low-voltage silo or a staircase entrance, to get in harmony with an external environment. Therefore, the communication device have high requirements on heat dissipation performance and operating noise.

In the box-shaped communication device, a plurality of different types of electronic components are usually installed in a housing, where different electronic components also have different requirements on heat dissipation. However, to satisfy a high requirement of an electronic component on heat dissipation in conventional technologies, usually a heat dissipation capability of the entire communication device is enhanced, for example, by directly increasing an air volume of a fan and a quantity of in-use fans. Such a solution lacks research and optimization for the device in practical application. Increasing the quantity of fans brings about an increase in a size and a weight of the communication device and causes loud noise.

For example, as shown in FIG. 2, a radio HUB unit 01 is used as an example. The radio HUB unit 01 may include a housing 011 and components that are disposed in the housing 011, such as a fan 012, a circuit board assembly 013, an optical module 014, and a power supply unit (power supply unit, PSU) 015. Solid-line arrows in FIG. 2 represent a flow path of air. It can be obviously learned from FIG. 2 that most of the air flows through the circuit board assembly 013 and the power supply unit 015 and only a small amount of the air can flow through the optical module 014. Electronic components such as the circuit board assembly 013 and the power supply unit 015 have a low requirement on a temperature, but the optical module 014 has a higher requirement on a temperature. In the industry, a temperature of a housing of the optical module 014 should be generally lower than 85°C. Some optical modules 014 have a higher requirement on heat dissipation to achieve higher operating performance. Therefore, in the radio HUB unit 01, the optical module 014 becomes a heat dissipation bottleneck of the entire radio HUB unit 01. It may be understood that, during practical application, the radio HUB unit 01 may include a plurality of electronic components of other types, which are not described herein.

In a current solution, a plurality of fans 012 are usually equipped, and air circulation between the inside of the housing 011 and an external environment is enhanced by increasing air volumes of the fans 012, to improve heat dissipation performance of the entire radio HUB unit 01. However, a large quantity of fans 012 bring an increase in manufacturing costs and usage costs of the radio HUB unit 01, and are also not conducive to reducing a size and a weight of the radio HUB unit 01. In addition, when a volume of air generated by the fan 012 is large, noise and energy consumption of the radio HUB unit 01 during operation are obviously higher, and this is not conducive to wide application of the radio HUB unit 01. In addition, during practical application, the circuit board assembly 013 and the power supply unit 015 also generate much heat. Because the optical module 014 is close to the circuit board assembly 013 and the power supply unit 015, the heat generated by the circuit board assembly 013 and the power supply unit 015 is also transferred to the optical module 014. This is not conducive to ensuring efficiency of heat dissipation for the optical module 014.

It may be understood that the problem with the radio HUB unit 01 also exists for other types of communication devices. Details are not described herein.

Therefore, an embodiment of this application provides a communication device with good heat dissipation performance, to avoid the problem about the increase in the size and the weight of the communication device due to excessive fans and loud noise when the plurality of fans are simultaneously operating.

To make the objectives, technical solutions, and advantages of this application clearer, the following further describes this application in detail with reference to the accompanying drawings and specific embodiments.

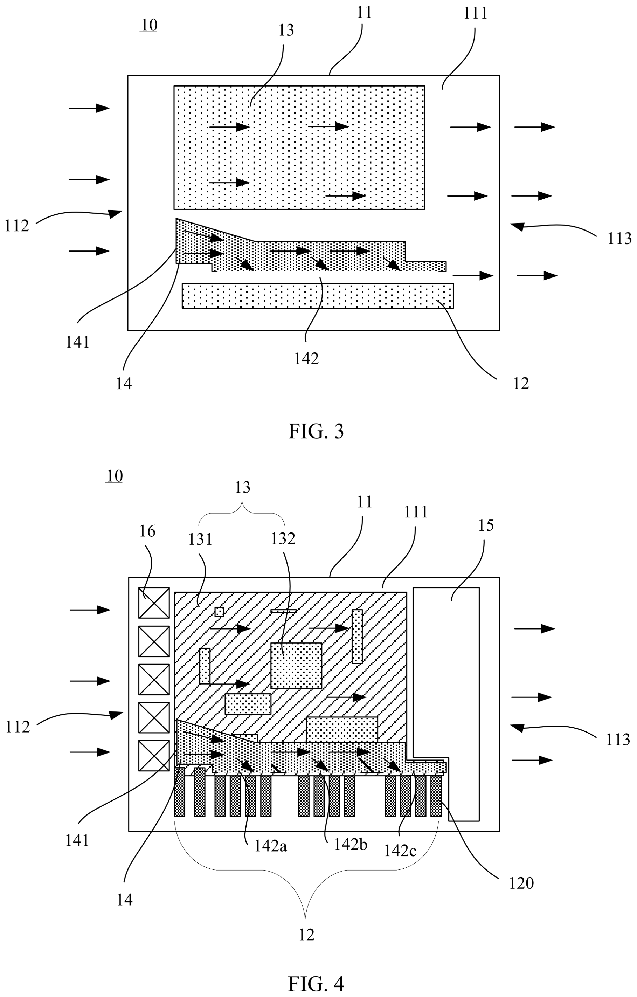

As shown in FIG. 3, in an example provided in this application, a communication device 10 may include a housing 11, a first heat emitting component 12, a second heat emitting component 13, and an air guide pipe 14. The housing 11 has a heat dissipation air duct 111 and an air inlet 112 and an air outlet 113 that are in communication with the heat dissipation air duct 111. The first heat emitting component 12 and the second heat emitting component 13 are both located in the heat dissipation air duct 111. The air guide pipe 14 is located in the heat dissipation air duct 111, the air guide pipe 14 has an air inlet end 141 and an air outlet end 142, and the air inlet end 141 is in communication with the air inlet 112. The first heat emitting component 12 is located at the air outlet end 142 of the air guide pipe 14. During practical application, external air may enter the heat dissipation air duct 111 from the air inlet 112, and is discharged from the air outlet 113. One part of air entering from the air inlet 112 flows through the second heat emitting component 13, to dissipate heat for the second heat emitting component 13, and is ultimately discharged from the air outlet 113. In addition, the air inlet end 141 of the air guide pipe 14 is in communication with the air inlet 112. Therefore, the other part of the air entering from the air inlet 112 enters the air guide pipe 14 from the air inlet end 141 and then is discharged from the air outlet end 142. The first heat emitting component 12 is located at the air outlet end 142 of the air guide pipe 14. Therefore, when the air discharged from the air outlet end 142 flows through the first heat emitting component 12, the first heat emitting component 12 can be cooled, thereby ensuring efficiency of heat dissipation for the first heat emitting component 12.

In the communication device 10 provided in this application, air flowing in from the air inlet 112 may be separated and guided through the air guide pipe 14, so that one part of the air can cool the second heat emitting component 13 to ensure heat dissipation performance of the second heat emitting component 13, and the other part of the air can be precisely guided to the first heat emitting component 12 through the air guide pipe 14 to ensure heat dissipation performance of the first heat emitting component 12. This can prevent hot air flowing through the second heat emitting component 13 from affecting the first heat emitting component 12.

Alternatively, it may be understood that, when the air guide pipe 14 is not disposed, heat generated by the first heat emitting component 12 and the second heat emitting component 13 converges in the heat dissipation air duct 111, and heat generated by the second heat emitting component 13 is transferred to the vicinity of the first heat emitting component 12, causing a high temperature in the vicinity of the first heat emitting component 12. After external cold air enters the heat dissipation air duct 111 from the air inlet 112 of the housing 11, turbulence is easily generated in the heat dissipation air duct 111 and this is not conducive to effective heat dissipation. In addition, during practical application, there is also a high requirement on a layout of the first heat emitting component 12 and the second heat emitting component 13. For example, to ensure that the first heat emitting component 12 is at a low temperature, in the heat dissipation air duct 111, the first heat emitting component 12 needs to be located at an upwind position of the second heat emitting component 13. However, under miniaturized and compact layout conditions of the communication device 10, it is difficult to satisfy the foregoing layout requirement. Therefore, there is a significant limitation.

In the example provided in this application, the air guide pipe 14 is disposed, so that cold air entering from the air inlet 112 can be effectively transferred to the first heat emitting component 12, thereby avoiding adverse impact between the first heat emitting component 12 and the second heat emitting component 13. Therefore, in the entire heat dissipation air duct 111, a layout of locations of the first heat emitting component 12 and the second heat emitting component 13 is flexible, to facilitate miniaturization and compactness of the communication device 10. For example, in a same operating condition, after the air guide pipe 14 is disposed, a temperature of the first heat emitting component 12 can decrease by about 5°C as compared with that before the air guide pipe 14 is disposed, thereby obviously improving efficiency of heat dissipation for the first heat emitting component 12.

It should be noted that the first heat emitting component 12 and the second heat emitting component 13 are two different heat emitting components in the communication device 10. The first heat emitting component 12 may include one electronic component, or may include a plurality of electronic components. Accordingly, the second heat emitting component 13 may include one electronic component, or may include a plurality of electronic components. Certainly, during practical application, the communication device 10 may further include more heat emitting components, and a quantity of electronic components included in each heat emitting component and types of the electronic components may be diversified.

For example, as shown in FIG. 4, in an example provided in this application, the first heat emitting component 12 specifically includes a plurality of optical modules 120 sequentially disposed, and the second heat emitting component 13 specifically includes a circuit board 131 and a plurality of electronic components 132 located on the circuit board 131. During practical application, the electronic component in the second heat emitting component 13 may be specifically a chip, a power conversion component, or the like. Specific types and a quantity of the electronic components are not limited in this application. In addition, the heat emitting components in the communication device 10 may further include a power supply unit 15.

Certainly, during practical application, the communication device 10 may further include more heat emitting components. Details are not described herein.

For ease of understanding the technical solutions of this application, the following provides detailed description by using an example in which the first heat emitting component 12 is the optical module 120 and the second heat emitting component 13 is a circuit board assembly.

As shown in FIG. 4, in the example provided in this application, the housing 11 is approximately rectangular, and the air inlet 112 and the air outlet 113 of the housing 11 are disposed opposite to each other, so that air circulation efficiency is high. A row of fans 16 (five shown in FIG. 4) is disposed at the air inlet 112, and the fans 16 can accelerate circulation of air, so that external air can enter the heat dissipation air duct 111 from the air inlet 112 at a high speed and is discharged from the air outlet 113.

During specific arrangement, there may be one, two, or more fans 16. During practical application, the quantity of disposed fans 16 may be flexibly adjusted according to an actual requirement. In addition, in some examples, the fan 16 may be disposed at the air outlet 113, or the fan 16 is disposed at both the air inlet 112 and the air outlet 113.

In addition, as shown in FIG. 4, the second heat emitting component 13 is located in the heat dissipation air duct 111, and the second heat emitting component 13 has a large area. The power supply unit 15 has a low requirement on heat dissipation, and may be disposed at a downwind position of the second heat emitting component 13. Air from the air inlet 112 flows through the second heat emitting component 13 and then flows through the power supply unit 15 to cool the second heat emitting component 13 and the power supply unit 15, and is ultimately discharged from the air outlet 113.

The plurality of optical modules 120 are arranged sequentially in a direction from the air inlet 112 to the air outlet 113, and one end (for example, an upper end in FIG. 4) of each optical module 120 is connected to a conductive line in the circuit board 131. The other end of each optical module 120 may be connected to an external cable through a port in the housing 11.

During practical application, a shape and a structure of the air guide pipe 14 may be diversified.

For example, as shown in FIG. 4 to FIG. 6, in an example provided in this application, the air guide pipe 14 is approximately a rectangular pipe structure, and has one air inlet end 141 and three air outlet ends. The three air outlet ends are an air outlet end 142a, an air outlet end 142b, and an air outlet end 142c. The air inlet end 141 is located at one end in a length direction of the air guide pipe 14, and the three air outlet ends are sequentially disposed in the length direction of the air guide pipe 14, to implement an effect of airflow going out from a side. In addition, by disposing the plurality of air outlet ends, the air guide pipe 14 can effectively dissipate heat from different positions of the first heat emitting component 12, thereby effectively improving an effect of heat dissipation for the first heat emitting component 12.

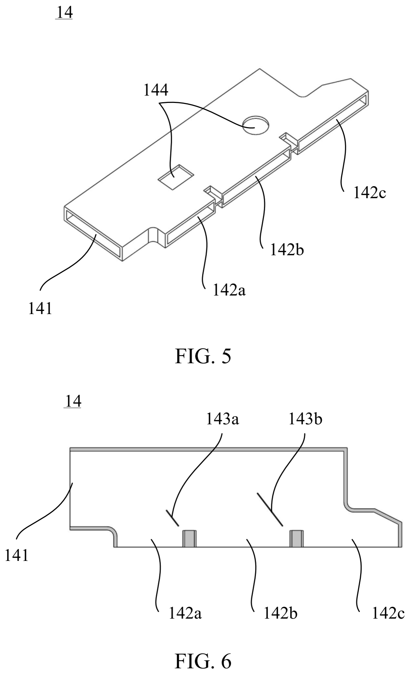

In addition, as shown in FIG. 6, in the example provided in this application, the air guide pipe 14 is further provided with two air deflectors: an air deflector 143a and an air deflector 143b. The air deflector is configured to guide a volume of flow in the air guide pipe 14 to each air outlet end. Specifically, after air enters the air guide pipe 14 from the air inlet end 141, when flowing through the air deflector 143a, a part of the airflow can be effectively guided to the air outlet end 142a; when flowing through the air deflector 143b, a part of the airflow can be effectively guided to the air outlet end 142b; and the rest of the airflow may be discharged from the air outlet end 142c.

During specific arrangement, a structure and a type of the air deflector may be diversified.

For example, as shown in FIG. 6, in the example provided in this application, each air deflector is a straight plate. The air deflector 143a and the air deflector 143b are both inclined toward the air inlet end 141, so that the airflow can be effectively guided to the corresponding air outlet end. In addition, a length of the air deflector 143a is slightly less than a length of the air deflector 143b, to implement even distribution of the airflow. Specifically, about one third of the airflow that enters the air guide pipe 14 from the air inlet end 141 is blocked by the air deflector 143a and guided to the air outlet end 142a; about one third of the airflow is blocked by the air deflector 143b and guided to the air outlet end 142b; and the remaining about one third of the airflow flows to the air outlet end 142c.

It may be understood that, the air deflectors 143a and 143b are merely examples for description. During practical application, the quantity, shapes, and positions of the air deflectors may be flexibly adjusted according to an actual requirement. In addition, a volume of flow of air discharged from each air outlet end may be the same or may be different, and details are not described herein.

In addition, during specific implementation, in a connection path between the air inlet end 141 and the air outlet end of the air guide pipe 14, the air guide pipe 14 is in a straight line shape or a curve shape. Alternatively, it may be understood that an overall shape of the air guide pipe 14 may be a straight line, a curve, or the like. During practical application, the shape of the air guide pipe 14 may be properly arranged according to an actual requirement, and details are not described herein.

During arrangement of the air outlet ends 142, the air guide pipe 14 may include one, two, or more air outlet ends.

When the air guide pipe 14 includes a plurality of air outlet ends, the plurality of air outlet ends may be sequentially disposed in the length direction of the air guide pipe 14. In addition, when the first heat emitting component 12 includes a plurality of optical modules 120, the plurality of optical modules 120 may be sequentially disposed in the length direction of the air guide pipe 14, to achieve a desirable heat dissipation effect.

For example, as shown in FIG. 4, in an example provided in this application, the first heat emitting component 12 includes a plurality of optical modules 120. The plurality of optical modules 120 may be sequentially disposed in the length direction of the air guide pipe 14, thereby effectively dissipating heat for each optical module 120.

Some optical modules 120 may be cooled by air discharged from the air outlet end 142a, some other optical modules 120 may be cooled by air discharged from the air outlet end 142b, and still some other optical modules 120 may be cool by air discharged from the air outlet end 142c. Details are not described herein.

In addition, during specific arrangement, a shape of the air inlet end 141 of the air guide pipe 14 may be diversified.

For example, as shown in FIG. 4, in an example provided in this application, the air inlet end 141 may be a horn-shaped structure, so that more air can enter the air guide pipe 14 from the air inlet end 141.

In addition, a diameter of the air inlet 112 may be greater than a diameter of the air inlet end 141, to ensure that there is sufficient air to dissipate heat for the second heat emitting component 13.

During specific arrangement, diameters and shapes of the air inlet 112 and the air inlet end 141 may be properly arranged according to an actual requirement, and details are not described herein.

In addition, as shown in FIG. 4, to ensure air circulation efficiency, in the example provided in this application, a row of fans 16 is disposed at the air inlet 112. The fans 16 can effectively inhale external air into the heat dissipation air duct 111, thereby improving heat dissipation performance of the entire communication device 10.

As shown in FIG. 4, among the plurality of fans 16, a corresponding fan 16 is disposed at the air inlet end 141, and sufficient air may be inhaled into the air guide pipe 14 through the fan 16, thereby ensuring heat dissipation performance of the first heat emitting component 12.

During specific arrangement, an additional fan may be disposed in the air guide pipe 14, or a fan may be disposed at each air outlet end 142, to improve a circulation speed of air, thereby ensuring heat dissipation performance of the first heat emitting component 12.

In addition, as shown in FIG. 5, in an example provided in this application, an outer surface of the air guide pipe 14 is further provided with an avoidance slot 144, and some electronic components in the second heat emitting component 13 may be located in the avoidance slot 144, to prevent position interference between the second heat emitting component 13 and the air guide pipe 14.

During specific arrangement, a quantity, a location, and a shape of the avoidance slot 144 may be properly arranged according to an actual requirement. This is not limited in this application.

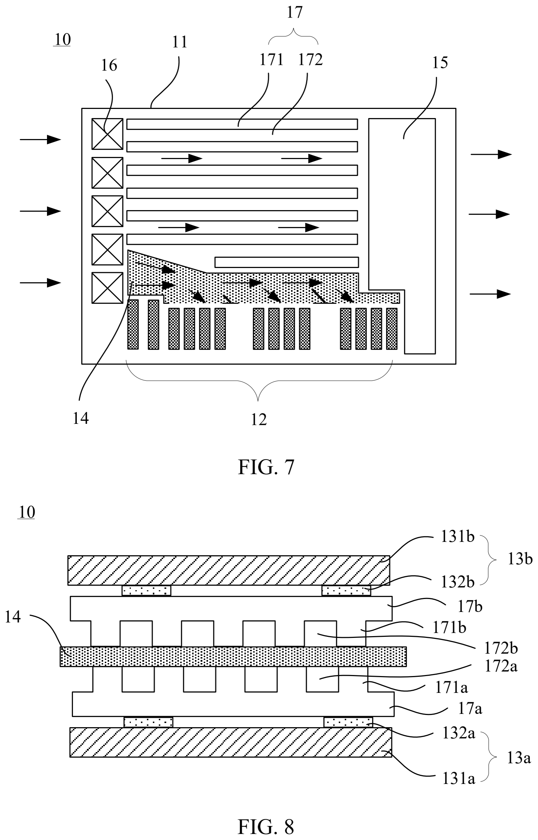

In addition, as shown in FIG. 4 and FIG. 7, in an example provided in this application, to improve heat dissipation performance of the second heat emitting component 13, the second heat emitting component 13 further includes one or more heat sinks 17. One side of the heat sink 17 is in thermal conduction contact with some or all of the electronic components 132 on the circuit board 131, so that heat of the corresponding electronic components 132 can be transferred to the heat sink 17 for dissipation. In addition, the heat sink 17 is further provided with heat sink fins 171, and an air duct 172 for air circulation is formed between two neighboring heat sink fins 171. When air flows through the air duct 172 between the heat sink fins 171, heat in the heat sink fins 171 can be quickly taken away, thereby effectively improving heat dissipation performance of the second heat emitting component 13.

As shown in FIG. 7, the air guide pipe 14 may be disposed between the heat sink 17 and the first heat emitting component 12, and can effectively isolate heat of the heat sink 17, to prevent heat transfer from the heat sink 17 to the first heat emitting component 12, thereby preventing the heat sink 17 from reducing heat dissipation performance of the first heat emitting component 12.

During specific arrangement, the air guide pipe 14 may have a thermal insulation side wall (not indicated in the figure), and the thermal insulation side wall may be disposed facing the heat sink 17 of the second heat emitting component 13. The thermal insulation side wall can prevent heat transfer from the heat sink 17 to the air guide pipe 14 which may cause a temperature rise of air in the air guide pipe 14, thereby helping ensure heat dissipation performance of the first heat emitting component 12.

A thermal insulation layer may be disposed on a side wall that is of the air guide pipe 14 and that faces the heat sink 17. Alternatively, the entire air guide pipe 14 may be made of a thermal insulation material. During practical application, a specific material of the air guide pipe 14 may be properly arranged according to an actual requirement.

Alternatively, as shown in FIG. 8, the communication device 10 may include two second heat emitting components and two heat sinks. The two second heat emitting components are a second heat emitting component 13a and a second heat emitting component 13b. The two heat sinks are a heat sink 17a and a heat sink 17b. The second heat emitting component 13a includes a circuit board 131a and an electronic component 132a that is disposed on the circuit board 131a. The electronic component 132a is in thermal conduction contact with the heat sink 17a, so that heat of the electronic component 132a can be transferred to the heat sink 17a for dissipation. The second heat emitting component 13b includes a circuit board 131b and an electronic component 132b that is disposed on the circuit board 131b. The electronic component 132b is in thermal conduction contact with the heat sink 17b, so that heat of the electronic component 132b can be transferred to the heat sink 17b for dissipation. The air guide pipe 14 may be located on the top of a fin 171a of the heat sink 17a and on the top of a fin 171b of the heat sink 17b. An outer wall of the air guide pipe 14 and the top of the fin 171a may jointly form an enclosed air duct 172a to improve airflow circulation efficiency, thereby helping improve efficiency of heat dissipation for the second heat emitting component 13a. The outer wall of the air guide pipe 14 and the top of the fin 171b may jointly form an enclosed air duct 172b to improve airflow circulation efficiency, thereby helping improve efficiency of heat dissipation for the second heat emitting component 13b.

In addition, the air guide pipe 14 is located between the heat sink 17a and the heat sink 17b, and can effectively isolate the heat sink 17a from the heat sink 17b, to prevent heat transfer between the heat sink 17a and the heat sink 17b, thereby effectively ensuring efficiency of heat dissipation for the second heat emitting component 13a and the second heat emitting component 13b.

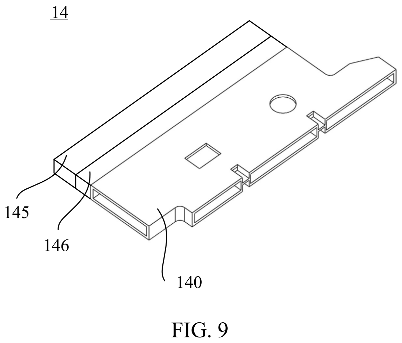

In addition, as shown in FIG. 9, in some examples, a heat dissipation portion 145 may be further disposed on a side that is of the air guide pipe 14 and that is close to the second heat emitting component 13, to improve heat dissipation performance of the second heat emitting component 13 through the heat dissipation portion 145.

Specifically, refer to FIG. 7 and FIG. 9. In an example provided in this application, the air guide pipe 14 may specifically include a pipe body 140, a heat dissipation portion 145, and a thermal insulation portion 146. The heat dissipation portion 145 may be made of a material with good heat conductivity, such as copper or aluminum. The thermal insulation portion 146 may be made of a material with good thermal insulation performance, such as plastic or a foam plate. During specific application, the heat dissipation portion 145 may be in thermal conduction contact with electronic components in the second heat emitting component 13, so that heat of the second heat emitting component 13 can be transferred to the heat dissipation portion 145 for dissipation, thereby effectively improving efficiency of heat dissipation for the second heat emitting component 13.

The thermal insulation portion 146 can effectively play an effect of thermally isolating the heat dissipation portion 145 from the pipe body 140, and can effectively prevent heat transfer from the heat dissipation portion 145 to the pipe body 140, thereby ensuring efficiency of heat dissipation for the first heat emitting component 12.

Alternatively, it may be understood that the heat dissipation portion 145 may take place of the heat sink 17, thereby effectively improving integrated design of the communication device 10.

Alternatively, in some examples, the heat dissipation portion 145 and the heat sink 17 may both exist. The heat dissipation portion 145 and the heat sink 17 may both be in thermal conduction contact with the second heat emitting component 13. A heat dissipation area of the second heat emitting component 13 may be effectively increased through the heat dissipation portion 145. Alternatively, the heat dissipation portion 145 may be in thermal conduction contact with the heat sink 17, thereby improving a heat dissipation area of the heat sink 17.

During specific arrangement, a specific shape of and a position arranged for the air guide pipe 14 may be flexibly adjusted according to an actual requirement. Details are not described herein.

In addition, during practical application, the communication device 10 may be specifically a radio HUB unit or a building baseband unit. A specific type of the communication device 10 is not limited in this application.

In various embodiments of this application, unless otherwise stated or there is a logic conflict, terms and/or descriptions in different embodiments are consistent and may be mutually referenced, and technical features in different embodiments may be combined based on an internal logical relationship thereof to form a new embodiment.

"A plurality of" in this application means two or more than two. In addition, "and/or" describes an association relationship between associated objects, and represents that three relationships may exist. For example, A and/or B may represent the following cases: Only A exists, both A and B exist, and only B exists, where A and B may be singular or plural.

It may be understood that various numbers in embodiments of this application are merely intended for differentiation for ease of description, and are not intended to limit the scope of embodiments of this application. Sequence numbers of the foregoing processes do not mean an execution sequence, and the execution sequence of the processes should be determined based on functions and internal logic of the processes.

## Claims

1. A communication device, comprising a housing, a first heat emitting component, a second heat emitting component, and an air guide pipe, wherein
the housing has a heat dissipation air duct and an air inlet and an air outlet that are in communication with the heat dissipation air duct, and the first heat emitting component and the second heat emitting component are both located in the heat dissipation air duct;
the air guide pipe is located in the heat dissipation air duct, the air guide pipe has an air inlet end and an air outlet end, and the air inlet end is in communication with the air inlet; and
the first heat emitting component is located at the air outlet end of the air guide pipe.

2. The communication device according to claim 1, wherein the air guide pipe has a thermal insulation side wall, and the thermal insulation side wall is disposed facing the second heat emitting component.

3. The communication device according to claim 1 or 2, wherein the air guide pipe is made of a thermal insulation material.

4. The communication device according to any one of claims 1 to 3, wherein the air guide pipe has one air inlet end and a plurality of air outlet ends; and
an air deflector is further disposed in the air guide pipe, and the air deflector is configured to guide a volume of flow in the air guide pipe to each air outlet end.

5. The communication device according to claim 4, wherein the air guide pipe is in a long strip shape, and the plurality of air outlet ends are sequentially disposed in a length direction of the air guide pipe; and
a plurality of air deflectors are disposed in the air guide pipe, and the plurality of air deflectors are sequentially disposed in the length direction of the air guide pipe.

6. The communication device according to any one of claims 1 to 5, wherein in a connection path between the air inlet end and the air outlet end of the air guide pipe, the air guide pipe is in a straight line shape or a curve shape.

7. The communication device according to any one of claims 1 to 6, wherein a diameter of the air inlet is greater than a diameter of the air inlet end; and
the communication device further comprises a first fan, and the first fan is located at the air inlet and/or the air outlet of the housing.

8. The communication device according to any one of claims 1 to 7, wherein the communication device further comprises a second fan; and
the second fan is located at the air inlet end or the air outlet end, or the second fan is located in the air guide pipe.

9. The communication device according to any one of claims 1 to 8, wherein an outer surface of the air guide pipe is provided with an avoidance slot, and at least a part of electronic components comprised in the second heat emitting component are located in the avoidance slot.

10. The communication device according to any one of claims 1 to 9, wherein the communication device further comprises a heat sink, and the heat sink is located in the heat dissipation air duct and is in thermal conduction contact with the second heat emitting component.

11. The communication device according to claim 10, wherein the heat sink has a heat sink fin, and the air guide pipe is located on the top of the heat sink fin.

12. The communication device according to any one of claims 1 to 11, wherein the air guide pipe has a pipe body and a heat dissipation portion that is disposed on an outer side of the pipe body, and the heat dissipation portion is in thermal conduction contact with the second heat emitting component.

13. The communication device according to claim 12, wherein the air guide pipe has a thermal insulation portion, and the thermal insulation portion is located between the pipe body and the heat dissipation portion.

14. The communication device according to any one of claims 1 to 13, wherein the first heat emitting component comprises a plurality of optical modules, and the plurality of optical modules are sequentially disposed in the length direction of the air guide pipe.

15. The communication device according to any one of claims 1 to 14, wherein the second heat emitting component comprises a circuit board and a plurality of electronic components located on the circuit board.

16. The communication device according to any one of claims 1 to 15, wherein the communication device is a building baseband unit or a radio HUB unit.
